# FASCICULE DE BREVET EUROPEEN

(11) **EP 1 771 741 B1**
(45) Date de publication et mention de la délivrance du brevet: **28.11.2007**
(21) Numéro de dépôt: 05850082.8
(22) Date de dépôt: 18.07.2005
(51) Int. Cl.: G01R 31/04, G01R 31/28

(54) **DISPOSITIF ET PROCEDE DE TEST D'AU MOINS UN JOINT CONDUCTEUR FORMANT UNE LIAISON ELECTRIQUE D'UN COMPOSANT ELECTRIQUE AVEC UN CIRCUIT IMPRIME**
VORRICHTUNG UND VERFAHREN ZUM TESTEN VON MINDESTENS EINER LEITENDEN VERBINDUNG ZUR BILDUNG EINER ELEKTRISCHEN VERBINDUNG ZWISCHEN EINEM ELEKTRISCHEN BAUTEIL UND EINER LEITERPLATTE
DEVICE AND METHOD FOR TESTING AT LEAST ONE CONDUCTING JOINT FORMING AN ELECTRICAL CONNECTION BETWEEN AN ELECTRIC COMPONENT AND A PRINTED CIRCUIT

(30) Priorité: 23.07.2004 FR 0408193
(43) Date de publication de la demande: 11.04.2007
(73) Titulaire: Valeo Electronique et Systèmes de Liaison, 78180 Montigny le Bretonneux (FR)
(72) Inventeur: IACOVELLA, Rocco, F-94400 Vitry Sur Seine (FR); MARTIN, Gérard-Marie, F-75008 Paris (FR); BATHELLIER, Laurent, F-94110 ARCUEIL (FR); DUTRIEUX, Laurent, F-93100 MONTREUIL (FR); PRIEUR, Philippe, F-94200 Charenton Le Pont (FR)
(74) Mandataire: de la Bigne, Guillaume Michel Marie
(86) Numéro de dépôt international: PCT/FR2005/001833
(87) Numéro de publication internationale: WO 2006/021649

(56) Documents cités:
- US-A- 4 751 721
- US-A- 5 963 039
- US-A- 6 028 431
- US-A1- 2004 036 466
- US-B1- 6 564 986

## Description

La présente invention concerne un dispositif et un procédé de test d'au moins un joint conducteur formant une liaison électrique d'un composant électrique avec un circuit imprimé.

Dans ce qui suit, on appellera composant électrique un composant dit électrique ou électronique.

La fabrication d'une carte électronique nécessite habituellement d'assembler électriquement et mécaniquement un composant électrique sur un circuit imprimé, grâce à au moins un joint conducteur formant une liaison électrique et mécanique du composant électrique avec le circuit imprimé.

Les joints conducteurs peuvent être réalisés par divers procédés d'assemblage, notamment par brasage (soudure avec apport de matière), soudure autogène, contact par pression ou emboîtement à force.

Habituellement, avant d'utiliser un procédé d'assemblage particulier pour réaliser des cartes électroniques en série, on souhaite évaluer la fiabilité de ce procédé. A cet effet, on a proposé de tester les joints conducteurs obtenus par un procédé d'assemblage particulier conformément à un protocole généralement adapté à la destination du composant électronique, par exemple une carte électronique pour véhicule automobile.

Pour tester un joint conducteur particulier, on connaît déjà dans l'état de la technique un dispositif de test comprenant un support formant un circuit imprimé, et un composant électrique comportant au moins une terminaison conductrice reliée au circuit imprimé par le joint conducteur.

Ce dispositif est généralement destiné uniquement au test du joint conducteur et n'est pas destiné à mettre en oeuvre ou tester une fonction particulière du composant électrique.

Le dispositif de test est disposé dans une enceinte d'essai pour y être soumis à des contraintes thermiques et mécaniques prédéterminées. Le test peut prévoir une série de cycles. Cette série peut comporter par exemple 250 cycles d'une heure chacun.

Pendant le test, le dispositif est connecté à des moyens externes à l'enceinte comprenant une alimentation électrique du dispositif de test et des moyens formant un testeur pour la détection d'une coupure électrique d'au moins un circuit testé. Ce circuit testé comporte habituellement une chaîne formée par des joints conducteurs à tester reliés entre eux en série. Le testeur est disposé à distance de l'enceinte d'essai, de manière que cette enceinte ne perturbe pas le fonctionnement du testeur.

Le dispositif de test comprend généralement un grand nombre de joints conducteurs à tester, c'est à dire plusieurs chaînes de joints conducteurs à tester, si bien qu'il faut prévoir un grand nombre de connexions (habituellement de l'ordre de plusieurs dizaines) entre le dispositif de test et le testeur, c'est à dire entre l'intérieur et l'extérieur de l'enceinte. Il n'est donc possible de tester que peu de dispositifs à la fois.

Pour remédier à cet inconvénient, on a proposé dans l'état de la technique, notamment dans US 2004/0036466, un dispositif de test dans lequel le support porte des moyens pour la détection d'une coupure électrique d'un circuit testé, ce circuit testé comportant habituellement une chaîne formée par des joints conducteurs à tester reliés entre eux en série.

Les moyens de détection décrits dans ce document comprennent une bascule électronique, associée à chaque chaîne, commandant un voyant lumineux destiné à s'allumer dès qu'une coupure est détectée dans la chaîne. Le cas échéant, il est proposé d'enregistrer les allumages successifs des voyants portés par le circuit imprimé au moyen d'une caméra vidéo.

Du fait que les moyens de détection de coupure électrique sont embarqués sur le circuit imprimé, il est possible de loger dans l'enceinte d'essai et de tester un relativement grand nombre de dispositifs à la fois.

Toutefois, certaines réglementations définissent la fiabilité d'un joint conducteur à partir d'une notion de "défaillance" de ce joint conducteur. Une défaillance correspond à la manifestation d'un nombre prédéterminé de coupures successives dans un intervalle de temps prédéterminé.

Or, un dispositif de test tel que décrit dans US 2004/0036466 ne permet pas de détecter des coupures successives dans une chaîne testée car il ne détecte que la première coupure de cette chaîne.

L'invention a pour but de proposer un dispositif de test capable de détecter une défaillance (au sens ci-dessus) d'un joint conducteur, ceci sans nécessiter de connecter pendant le test le dispositif à des moyens de détections extérieurs.

A cet effet, l'invention a pour objet un dispositif de test d'au moins un joint conducteur formant une liaison électrique d'un composant électrique avec un circuit imprimé, du type décrit dans US 2004/0036466, comprenant :
- un support formant un circuit imprimé,
- un composant électrique comportant au moins une terminaison conductrice reliée au circuit imprimé par le joint conducteur,
- des moyens, portés par le support, pour la détection d'une coupure électrique d'un circuit testé comportant le joint conducteur,
caractérisé en ce qu'il comprend des moyens, portés par le support, pour le stockage de dates successives de coupure.

L'invention permet de détecter une défaillance, correspondant à la manifestation d'un nombre prédéterminé de coupures successives dans un intervalle de temps prédéterminé, à partir des dates de coupure stockées dans le dispositif de test. Pendant le test, aucune connexion vers des moyens de détection externes à l'enceinte d'essai n'est requise.

Les dates de coupure stockées peuvent être récupérées à la fin du test pour être transférées vers des moyens d'analyse adéquats susceptibles d'identifier les défaillances en fonction de l'historique des coupures.

De façon optionnelle, le dispositif de test peut comprendre des moyens, portés par le support, de détermination d'une défaillance du circuit testé.

Ainsi, il est possible de déterminer en temps réel si une défaillance se produit.

Un dispositif de test selon l'invention peut en outre comporter l'une ou plusieurs des caractéristiques suivantes :
- les moyens de stockage comprennent une mémoire non-volatile ;
- le dispositif de test comprend des moyens de mesure d'au moins un paramètre environnemental du support et des moyens de stockage d'au moins une valeur de ce paramètre environnemental ;
- le paramètre environnemental est choisi parmi une température, une accélération à laquelle est soumis le dispositif, et un degré d'humidité ;
- le dispositif de test comporte plusieurs terminaisons conductrices de composant électrique reliées chacune au circuit imprimé par un joint conducteur, le circuit testé comportant une chaîne formée par les joints conducteurs reliés entre eux en série ;
- le circuit testé comporte un pont diviseur de tension comportant des moyens résistifs montés en série avec la chaîne ;
- les moyens résistifs comprennent deux dipôles résistifs montés en parallèle ;
- les moyens de détection d'une coupure comprennent des moyens de comparaison d'une valeur d'une tension de sortie du pont avec un seuil prédéterminé ;
- les moyens de détection comprennent des moyens d'analyse logique munis d'au moins une entrée reliée au circuit testé et d'au moins une sortie reliée aux moyens de stockage ;
- les moyens d'analyse logique sont munis de plusieurs entrées reliées chacune à un circuit testé correspondant ;
- les moyens d'analyse logique sont du type réseau logique programmable FPGA (Field Programmable Gate Array, conformément à la terminologie anglaise), ou du type microcontrôleur ;
- chaque entrée des moyens d'analyse logique est doublée afin de redondance ;
- les moyens de stockage comprennent une mémoire volatile des moyens d'analyse logique ;
- les moyens d'analyse logique comportent les moyens de détermination de défaillance ;
- le joint conducteur est formé par brasage, soudure autogène, contact par pression ou emboîtement à force ;
- le support comprend des moyens de connexion à un dispositif externe, destinés notamment à relier les moyens de stockage au dispositif externe ;
- le dispositif de test comprend des moyens portés par le support, pour le stockage de paramètres d'état de fonctionnement du dispositif en cas de coupure d'alimentation électrique de ce dispositif.

L'invention a également pour objet un procédé de test d'au moins un joint conducteur formant une liaison électrique d'un composant électrique avec un circuit imprimé, du type dans lequel on détecte une coupure électrique d'un circuit testé comportant le joint conducteur, caractérisé en ce que l'on détecte la coupure au moyen d'un dispositif tel que défini ci-dessus.

Un procédé de test selon l'invention peut en outre comporter l'une ou plusieurs des caractéristiques suivantes :
- la coupure est détectée par mesure d'un paramètre de régime permanent du circuit testé alimenté en continu ;
- la coupure est détectée par mesure d'un paramètre de régime transitoire du circuit testé alimenté de façon variable, de préférence impulsionnelle.

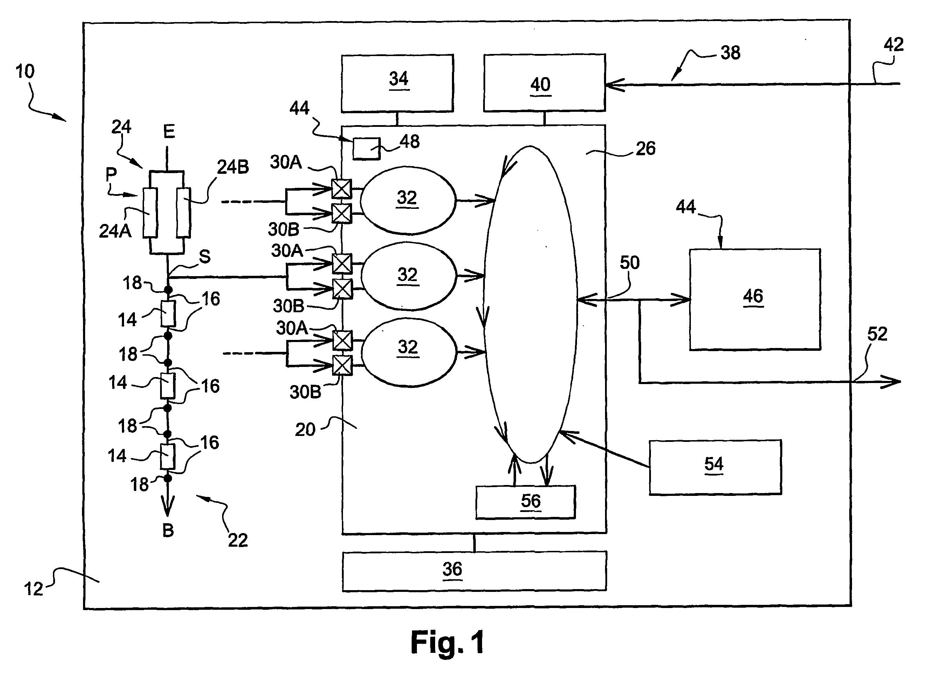

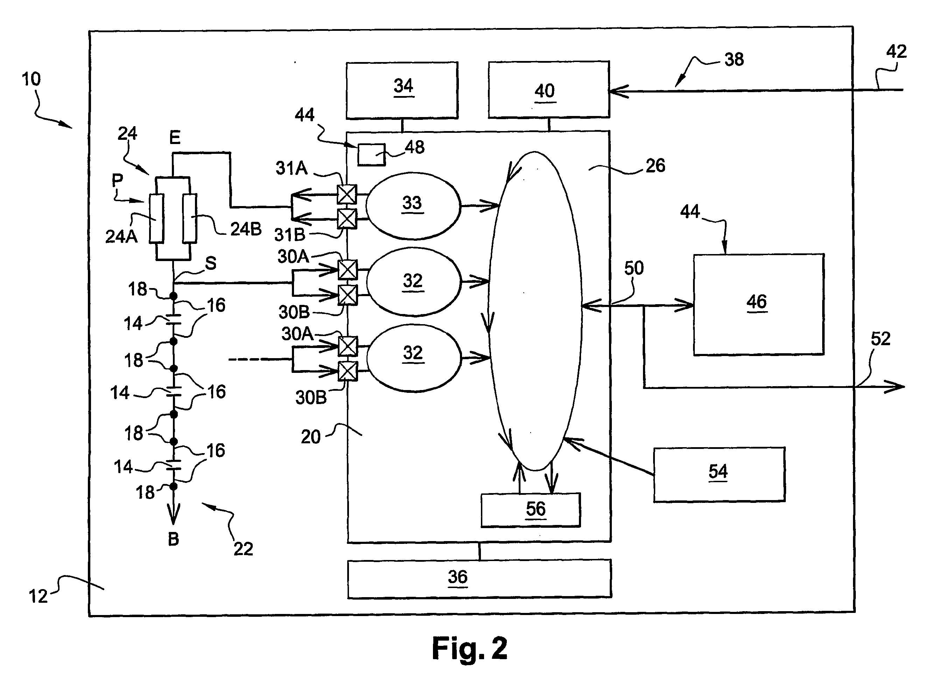

L'invention sera mieux comprise à la lecture de la description qui va suivre, donnée uniquement à titre d'exemple et faite en se référant aux figures 1 et 2 représentant schématiquement un dispositif de test selon des premier et second modes de réalisation de l'invention.

On a représenté sur la figue 1 un dispositif de test, selon un premier mode de réalisation de l'invention, désigné par la référence générale 10.

Ce dispositif 10 comprend un support formant un circuit imprimé 12 et des composants électriques 14 portant chacun au moins une terminaison conductrice 16 reliée au circuit imprimé par un joint conducteur 18.

Les joints conducteurs 18 relient électriquement mais aussi mécaniquement les composants électriques 14 avec le circuit imprimé 12.

Dans l'exemple illustré, les joints conducteurs 18 sont de type brasé et les composants électriques 14 sont des dipôles passifs, par exemple de type résistif.

En variante, les composants électriques 14 peuvent comprendre plus de deux pôles. Dans ce cas, les composants électriques pourraient être du type monté en surface, notamment du type BGA (Ball Grid Array conformément à la terminologie anglaise).

Le dispositif 10 est destiné à tester la fiabilité des joints conducteurs 18 en détectant les coupures intempestives de ces joints conducteurs 18.

A cet effet, le circuit imprimé 12 porte des moyens 20 pour la détection d'une coupure électrique d'un circuit testé 22 comportant au moins un joint conducteur 18.

Dans l'exemple décrit, le dispositif 10 comprend plusieurs circuits testés 22 dont un seul est représenté sur la figure 1.

De préférence, chaque circuit testé 22 comporte une chaîne formée par des joints conducteurs 18 reliés entre eux en série.

Les joints conducteurs 18 d'une même chaîne relient électriquement le circuit imprimé 12 à plusieurs terminaisons conductrices 16 d'un seul composant électrique 14 ou de plusieurs composants électriques 14.

Le circuit imprimé 12 porte également des moyens résistifs 24 montés en série avec la chaîne du circuit testé 22 de façon à former un pont diviseur de tension P.

Dans l'exemple illustré, les moyens résistifs 24 comprennent deux dipôles résistifs 24A, 24B montés en parallèles afin de redondance.

Le pont diviseur P comprend deux bornes B et E entre lesquelles est appliquée une tension d'entrée du pont.

Dans le mode de réalisation représenté sur la figure 1, la tension appliquée entre les bornes B et E est une tension continue.

Le pont diviseur P comprend également une borne S, intercalée entre le circuit testé 22 et les moyens résistifs 24, formant une sortie de tension du pont diviseur P.

Les moyens de détection 20 comprennent de plus des moyens 26 d'analyse logique munis d'entrées 30A, 30B reliées chacune à la sortie S du pont diviseur P d'un circuit testé 22 correspondant. De préférence, chaque entrée 30A, 30B est doublée afin de redondance.

Dans l'exemple illustré, les moyens d'analyse logique 26 comprennent un circuit du type réseau logique programmable FPGA (Field Programmable Gate Array, conformément à terminologie anglaise). Ce type de moyens d'analyse logique est particulièrement bien adapté au relativement grand nombre d'entrées nécessaires.

En variante, les moyens d'analyse logique 26 pourraient être du type microcontrôleur.

Les moyens d'analyse logique 26 comprennent des moyens classiques 32 de comparaison de la valeur de la tension de sortie du pont diviseur P avec un seuil prédéterminé.

On notera que des seuils prédéterminés différents peuvent être associés à des entrées différentes.

On a également représenté sur la figure 1 des moyens classiques 34 formant oscillateur et des moyens classiques 36 formant mémoire d'initialisation. Ces moyens 34,36 sont associés de façon connue en soi aux moyens d'analyse logique 26.

Les moyens d'analyse logique 26 sont alimentés électriquement à l'aide de moyens classiques 38. Ces moyens d'alimentation 38 comprennent des moyens classiques formant un régulateur 40, associé aux moyens d'analyse logique 26, susceptible d'être raccordé à une alimentation électrique externe au dispositif 10 par l'intermédiaire de moyens de connexion classiques 42.

Le dispositif de test 10 comprend des moyens 44, portés par le circuit imprimé 12, pour le stockage de dates successives de coupures détectées par les moyens 20.

De préférence, les moyens de stockage 44 comprennent une mémoire non volatile 46 et une mémoire volatile 48 intégrée dans les moyens d'analyse logique 26. Ces moyens d'analyse logique 26 comportent au moins une sortie 50 reliée à la mémoire non volatile 46.

Par ailleurs, la mémoire non volatile 46 est susceptible d'être reliée à des moyens classiques de lecture de cette mémoire, externe au dispositif 10, à l'aide de moyens classiques de connexion 52.

Les moyens d'analyse logique 26, le régulateur 40, et la mémoire non volatile 46 portés par le support 12, forment des moyens pour le stockage de paramètres d'état de fonctionnement du dispositif 10 en cas de coupure d'alimentation électrique de ce dispositif.

A cet effet, le régulateur 40 est apte à alimenter électriquement les moyens d'analyse logique 26 et la mémoire non volatile 46 pendant un certain temps suivant la coupure d'alimentation électrique.

De préférence, le circuit imprimé 12 porte également des moyens 54 de mesure d'au moins un paramètre environnemental de ce circuit imprimé 12, et des moyens de stockage d'au moins une valeur de ce paramètre environnemental, constitués par exemple par la mémoire volatile 48.

Dans l'exemple illustré, le paramètre environnemental mesuré par les moyens 54 est une température. En variante, ce paramètre pourrait être une accélération à laquelle est soumis le dispositif de test 10 ou un degré humidité.

Le fonctionnement des moyens d'analyse logique 26 est classique, l'état des entrées étant surveillé conformément à un cycle cadencé par une horloge 56.

On décrira ci-dessous les principaux aspects, liés à l'invention, du fonctionnement du dispositif de test 10 selon le premier mode de réalisation.

Le dispositif de test 10, comportant plusieurs circuits 22 à tester, est logé dans une enceinte d'essai classique pour y être soumis à des contraintes thermiques et mécaniques conformément à un protocole prédéterminé.

Dans l'enceinte d'essai, le dispositif 10 est raccordé uniquement aux moyens d'alimentation électrique à l'aide des moyens de connexion 42. L'enceinte d'essai peut donc comporter un relativement grand nombre de dispositifs de test 10 tel que celui représenté sur la figure unique.

On notera que, au cours du test, le dispositif 10 est soumis à des températures pouvant varier par exemple de -40° à +170°C. L'homme du métier choisira donc des moyens d'analyse logique 26 et une mémoire non volatile 46 résistant à ces températures.

Au cours du test, les moyens d'analyse logique 26 surveillent les entrées 30A, 30B et relèvent les changements d'états de ces dernières correspondant à des coupures des circuits testés 22.

Ainsi, une coupure est détectée par mesure d'un paramètre de régime permanent du circuit testé 22 alimenté en continu.

Les moyens d'analyse logique 26 stockent, dans les mémoires non volatile 46 et/ou volatile 48, les dates successives des différentes coupures ainsi que des indications identifiant les circuits testés 22 dans lesquels ont lieu ces coupures.

Les moyens d'analyse logique 26 enregistrent également, au moins dans la mémoire non volatile 46, les paramètres environnementaux mesurés par les moyens 54 au moment où les coupures des circuits 22 se produisent.

A la fin du test, qui peut durer plusieurs jours, les dates de coupure stockées dans la mémoire non volatile 46 peuvent être récupérées, à l'aide des moyens de connexion 52, pour être transférées vers des moyens classiques d'analyse susceptibles d'identifier des défaillances des différents circuits testés 22 en fonction de l'historique des coupures.

Une défaillance est définie généralement comme la manifestation d'un nombre prédéterminé de coupures successives intervenant dans un même circuit testé, ceci dans un intervalle de temps prédéterminé.

Le test prévoyant une série de cycles, en cas de coupure d'alimentation électrique du dispositif 10, les moyens 26, 40, 46 stockent notamment le nombre de cycles déjà réalisés, et la durée restante du cycle en cours.

En variante, les moyens de détermination de défaillance pourraient être intégrés dans les moyens d'analyse logique 26, les moyens de détermination étant ainsi portés par le circuit intégré 12. Dans ce cas, la détermination des défaillances serait faite au cours du test, par exemple à partir des informations stockées dans la mémoire volatile 48.

On a représenté sur la figue 2 un dispositif de test, selon un second mode de réalisation de l'invention. Sur cette figure 2, les éléments analogues à ceux de la figure 1 sont désignés par des références identiques.

Dans ce mode de réalisation, les dipôles 14 sont de type capacitif.

Les moyens d'analyse logique 26 comportent une sortie 31 A, 31 B, doublée afin de redondance, et reliée à la borne E.

Les moyens d'analyse logique 26 comportent également des moyens 33 de génération d'une tension impulsionnelle destinée à être appliquée entre les bornes E et B du circuit testé 22.

Dans ce mode de réalisation, une coupure du circuit testé 22 est détectée par mesure d'un paramètre de régime transitoire du circuit testé 22 alimenté de façon variable, de préférence impulsionnelle, par les moyens d'analyse logique 26.

L'invention ne se limite pas aux modes de réalisation décrits ci-dessus.

En particulier, le circuit imprimé 12 peut être équipé de voyants lumineux susceptibles chacun de s'allumer lorsqu'une coupure ou une défaillance intervient dans un circuit testé 22.

Parmi les avantages de l'invention, on notera que le dispositif 10 permet de tester des joints conducteurs reliant le circuit intégré à des composants de type très variés, passifs ou actifs.

## Revendications

1. Dispositif de test d'au moins un joint conducteur (18) formant une liaison électrique d'un composant électrique avec un circuit imprimé (12), du type comprenant :
- un support formant un circuit imprimé (12),
- un composant électrique (14) comportant au moins une terminaison conductrice (16) reliée au circuit imprimé (12) par le joint conducteur (18),
- des moyens (20), portés par le support (12), pour la détection d'une coupure électrique d'un circuit testé (22) comportant le joint conducteur (18),
**caractérisé en ce qu'**il comprend des moyens (44), portés par le support, pour le stockage de dates successives de coupure.

2. Dispositif de test selon la revendication 1, dans lequel les moyens de stockage (44) comprennent une mémoire non-volatile (46).

3. Dispositif de test selon la revendication 1 ou 2, comprenant des moyens (54) de mesure d'au moins un paramètre environnemental du support (12) et des moyens (48) de stockage d'au moins une valeur de ce paramètre environnemental.

4. Dispositif de test selon la revendication 3, dans lequel le paramètre environnemental est choisi parmi une température, une accélération à laquelle est soumis le dispositif, et un degré d'humidité.

5. Dispositif de test selon l'une quelconque des revendications précédentes, comportant plusieurs terminaisons conductrices (16) de composant électrique (14) reliées chacune au circuit imprimé (12) par un joint conducteur (18), le circuit testé (22) comportant une chaîne formée par les joints conducteurs (18) reliés entre eux en série.

6. Dispositif de test selon la revendication 5, dans lequel le circuit testé (22) comporte un pont diviseur de tension (P) comportant des moyens résistifs (24) montés en série avec la chaîne.

7. Dispositif de test selon la revendication 6, dans lequel les moyens résistifs (24) comprennent deux dipôles résistifs (24A, 24B) montés en parallèle.

8. Dispositif de test selon la revendication 6 ou 7, dans lequel les moyens (20) de détection d'une coupure comprennent des moyens (32) de comparaison d'une valeur d'une tension de sortie du pont (P) avec un seuil prédéterminé.

9. Dispositif de test selon l'une quelconque des revendications précédentes, dans lequel les moyens de détection (20) comprennent des moyens d'analyse logique (26) munis d'au moins une entrée (30A, 30B) reliée au circuit testé (22) et d'au moins une sortie (50) reliée aux moyens de stockage (44).

10. Dispositif de test selon la revendication 9, dans lequel les moyens d'analyse logique sont munis de plusieurs entrées (30A, 30B) reliées chacune à un circuit testé (22) correspondant.

11. Dispositif de test selon la revendication 9 ou 10, dans lequel les moyens d'analyse logique (26) sont du type réseau logique programmable FPGA (Field Programmable Gate Array, conformément à la terminologie anglaise) ou du type microcontrôleur.

12. Dispositif de test selon l'une quelconque des revendications 9 à 11, dans lequel chaque entrée (30A, 30B) des moyens d'analyse logique (26) est doublée afin de redondance.

13. Dispositif de test selon l'une quelconque des revendications 9 à 12, dans lequel les moyens de stockage (44) comprennent une mémoire volatile (48) des moyens d'analyse logique (26).

14. Dispositif de test selon l'une quelconque des revendications précédentes, comprenant des moyens (26), portés par le support (12), de détermination d'une défaillance du circuit testé (22), une défaillance correspondant à la manifestation d'un nombre prédéterminé de coupures successives dans un intervalle de temps prédéterminé.

15. Dispositif de test selon l'une quelconque des revendications 9 à 12 prise en combinaison avec la revendication 14, dans lequel les moyens d'analyse logique (26) comportent les moyens de détermination de défaillance.

16. Dispositif de test selon l'une quelconque des revendications précédentes, dans lequel le joint conducteur est formé par brasage, soudure autogène, contact par pression ou emboîtement à force.

17. Dispositif de test selon l'une quelconque des revendications précédentes, dans lequel le support (12) comprend des moyens (52) de connexion à un dispositif externe, destinés notamment à relier les moyens de stockage (44) au dispositif externe.

18. Dispositif de test selon l'une quelconque des revendications précédentes, comprenant des moyens (26, 40, 46) portés par le support (12), pour le stockage de paramètres d'état de fonctionnement du dispositif en cas de coupure d'alimentation électrique de ce dispositif.

19. Procédé de test d'au moins un joint conducteur (18) formant une liaison électrique d'un composant électrique avec un circuit imprimé (12), du type dans lequel on détecte une coupure électrique d'un circuit testé (22) comportant le joint conducteur (18), **caractérisé en ce que** l'on détecte la coupure au moyen d'un dispositif selon l'une quelconque des revendications précédentes.

20. Procédé de test selon la revendication 19, dans lequel la coupure est détectée par mesure d'un paramètre de régime permanent du circuit testé (22) alimenté en continu.

21. Procédé de test selon la revendication 19, dans lequel la coupure est détectée par mesure d'un paramètre de régime transitoire du circuit testé (22) alimenté de façon variable, de préférence impulsionnelle.

## Claims

1. A test device for testing at least one conductive joint (18) forming an electrical connection between an electrical component and a printed circuit (12), the device being of the type comprising:
• a support forming a printed circuit (12);
• an electrical component (14) having at least one conductive termination (16) connected to the printed circuit (12) by the conductive joint (18); and
• detector means (20) carried by the support (12) to detect an electrical interruption of a circuit under test (22) including the conductive joint (18);
the device being **characterized in that** it includes storage means (44) carried by the support for storing the successive times of interruptions.

2. A test device according to claim 1, in which the storage means (44) comprise a non-volatile memory (46).

3. A test device according to claim 1 or claim 2, including means (54) for measuring at least one environmental parameter associated with the support (12) and storage means (48) for storing at least one value of said environmental parameter.

4. A test device according to claim 3, in which the environmental parameter is selected from: a temperature, an acceleration to which the device is subjected, and a degree of humidity.

5. A test device according to any preceding claim, including a plurality of electrical component conductive terminations (16), each connected to the printed circuit (12) via a conductive joint (18), the circuit under test (22) having a run formed by the conductive joints (18) interconnected in series.

6. A test device according to claim 5, in which the circuit under test (22) includes a voltage divider bridge (P) including resistive means (24) connected in series with the run.

7. A test device according to claim 6, in which the resistive means (24) comprise two two-terminal resistors (24A, 24B) connected in parallel.

8. A test device according to claim 6 or claim 7, in which the means (20) for detecting an interruption comprise means (32) for comparing a voltage output by the bridge (P) with a predetermined threshold.

9. A test device according to any preceding claim, in which the detector means (20) comprise logic analysis means (26) provided with the least one input (30A, 30B) connected to the circuit under test (22) and at least one output (50) connected to the storage means (44).

10. A test device according to claim 9, in which the logic analysis means are provided with a plurality of inputs (30A, 30B) each connected to a corresponding circuit under test (22).

11. A test device according to claim 9 or claim 10, in which the logic analysis means (26) are of the field programmable gate array type or of the microcontroller type.

12. A test device according to any one of claims 9 to 11, in which each input (30A, 30B) of the logic analysis means (26) is duplicated for redundancy purposes.

13. A test device according to any one of claims 9 to 12, in which the storage means (44) include a volatile memory (48) of the logic analysis means (26).

14. A test device according to any preceding claim, including means (26) carried by the support (12) for determining a failure of the circuit under test (22), a failure corresponding to a predetermined number of successive interruptions occurring in a predetermined time interval.

15. A test device according to any one of claims 9 to 12 taken in combination with claim 14, in which the logic analysis means (26) include the means for determining failure.

16. A test device according to any preceding claim, in which the conductive joint is formed by soldering, autogenous welding, contact under pressure, or forced engagement.

17. A test device according to any preceding claim, in which the support (12) includes connection means (52) for connection to an external device, in particular for connecting the storage means (44) to the external device.

18. A test device according to any preceding claim, including means (26, 40, 46) carried by the support (12) for storing operating state parameters of the device in the event of an interruption in the electrical power supply to the device.

19. A test method for testing at least one conductive joint (18) forming an electrical connection between an electrical component and a printed circuit (12), the method being of the type in which an electrical interruption is detected in a circuit under test (22) including the conductive joint (18), the method being **characterized in that** the interruption is detected by means of a device according to any preceding claim.

20. A test method according to claim 19, in which the interruption is detected by measuring a steady state parameter of the circuit under test (22) while fed with DC.

21. A test method according to claim 19, in which the interruption is detected by measuring a transient state parameter of the circuit under test (22) while fed in variable manner, preferably with pulses.

## Patentansprüche

1. Vorrichtung zum Testen von mindestens einer leitenden Verbindung (18), die eine elektrische Verbindung zwischen einem elektrischen Bauteil und einer Leiterplatte (12) bildet, umfassend:
- einen Träger, der eine Leiterplatte (12) bildet,
- ein elektrisches Bauteil (14), das mindestens einen leitenden Abschluss (16) aufweist, der mit der Leiterplatte (12) über die leitende Verbindung (18) verbunden ist,
- vom Träger (12) getragene Mittel (20) zur Detektion einer elektrischen Unterbrechung einer getesteten Schaltung (22), welche die leitende Verbindung (18) beinhaltet,
**dadurch gekennzeichnet, dass** sie vom Träger getragene Mittel (44) zur Speicherung sukzessiver Unterbrechungsdaten umfasst.

2. Vorrichtung zum Testen nach Anspruch 1, bei welcher die Speichermittel (44) einen nichtflüchtigen Speicher (46) umfassen.

3. Vorrichtung zum Testen nach Anspruch 1 oder 2, welche Mittel (54) zur Messung mindestens eines Umgebungsparameters des Trägers (12) und Mittel (48) zur Speicherung mindestens eines Werts dieses Umgebungsparameters umfasst.

4. Vorrichtung zum Testen nach Anspruch 3, bei welcher der Umgebungsparameter aus einer Temperatur, einer Beschleunigung, der die Vorrichtung unterworfen ist, und einem Feuchtigkeitsgrad gewählt wird.

5. Vorrichtung zum Testen nach einem der vorangehenden Ansprüche, welche mehrere leitende Abschlüsse (16) des elektrischen Bauteils (14) aufweist, die jeweils mit der Leiterplatte (12) über eine leitende Verbindung (18) verbunden sind, wobei die getestete Schaltung (22) eine Kette beinhaltet, die von den leitenden Verbindungen (18) gebildet wird, die miteinander in Reihe verbunden sind.

6. Vorrichtung zum Testen nach Anspruch 5, bei welcher die getestete Schaltung (22) einen Spannungsteiler (P) aufweist, welcher Widerstandsmittel (24) beinhaltet, die in Reihe mit der Kette montiert sind.

7. Vorrichtung zum Testen nach Anspruch 6, bei welcher die Widerstandsmittel (24) zwei resistive Zweipole (24A, 24B) umfassen, die parallel montiert sind.

8. Vorrichtung zum Testen nach Anspruch 6 oder 7, bei welcher die Mittel (20) zur Detektion einer Unterbrechung Mittel (32) zum Vergleich eines Werts einer Ausgangsspannung des Spannungsteilers (P) mit einer vorbestimmten Schwelle umfassen.

9. Vorrichtung zum Testen nach einem der vorangehenden Ansprüche, bei welcher die Detektionsmittel (20) Mittel (26) zur logischen Analyse umfassen, die ausgestattet sind mit mindestens einem Eingang (30A, 30B), der mit der getesteten Schaltung (22) verbunden ist, und mit mindestens einem Ausgang (50), der mit den Speichermitteln (44) verbunden ist.

10. Vorrichtung zum Testen nach Anspruch 9, bei welcher die Mittel zur logischen Analyse mit mehreren Eingängen (30A, 30B) ausgestattet sind, die jeweils mit einer entsprechenden getesteten Schaltung (22) verbunden sind.

11. Vorrichtung zum Testen nach Anspruch 9 oder 10, bei welcher die Mittel (26) zur logischen Analyse zum Typ der programmierbaren logischen FPGA-Schaltung (Field Programmable Gate Array laut der englischen Terminologie) oder zum Mikrokontroller-Typ gehören.

12. Vorrichtung zum Testen nach einem der Ansprüche 9 bis 11, bei welcher jeder Eingang (30A, 30B) der Mittel (26) zur logischen Analyse zwecks Redundanz verdoppelt ist.

13. Vorrichtung zum Testen nach einem der Ansprüche 9 bis 12, bei welcher die Speichermittel (44) einen flüchtigen Speicher (48) der Mittel (26) zur logischen Analyse umfassen.

14. Vorrichtung zum Testen nach einem der vorangehenden Ansprüche, welche vom Träger (12) getragene Mittel (26) zur Bestimmung eines Versagens der getesteten Schaltung (22) umfasst, wobei ein Versagen der Manifestation einer vorbestimmten Anzahl sukzessiver Unterbrechungen in einem vorbestimmten Zeitintervall entspricht.

15. Vorrichtung zum Testen nach einem der Ansprüche 9 bis 12 in Kombination mit Anspruch 14, bei welcher die Mittel (26) zur logischen Analyse die Mittel zur Bestimmung des Versagens beinhalten.

16. Vorrichtung zum Testen nach einem der vorangehenden Ansprüche, bei welcher die leitende Verbindung durch Hartlöten, Autogenschweißen, Druckkontaktierung oder Pressfitting gebildet wird.

17. Vorrichtung zum Testen nach einem der vorangehenden Ansprüche, bei welcher der Träger (12) Mittel (52) zur Verbindung mit einer externen Vorrichtung umfasst, die insbesondere dazu gedacht sind, die Speichermittel (44) mit der externen Vorrichtung zu verbinden.

18. Vorrichtung zum Testen nach einem der vorangehenden Ansprüche, welche vom Träger (12) getragene Mittel (26, 40, 46) umfasst zwecks Speicherung von Parametern für den Funktionszustand der Vorrichtung im Fall einer Unterbrechung der elektrischen Versorgung dieser Vorrichtung.

19. Verfahren zum Testen von mindestens einer leitenden Verbindung (18), die eine elektrische Verbindung zwischen einem elektrischen Bauteil und einer Leiterplatte (12) bildet, und zwar jenes Typs, bei welchem eine elektrische Unterbrechung einer getesteten Schaltung (22), welche die leitende Verbindung (18) aufweist, detektiert wird, **dadurch gekennzeichnet, dass** die Unterbrechung mittels einer Vorrichtung nach einem der vorangehenden Ansprüche detektiert wird.

20. Verfahren zum Testen nach Anspruch 19, bei welchem die Unterbrechung durch Messung eines Parameters für permanenten Betrieb der getesteten Schaltung (22) detektiert wird, die kontinuierlich gespeist wird.

21. Verfahren zum Testen nach Anspruch 19, bei welchem die Unterbrechung durch Messung eines Parameters für zeitweiligen Betrieb der getesteten Schaltung (22) detektiert wird, die in variabler Weise gespeist wird, vorzugsweise impulsweise.
